Europäisches Patentamt

European Patent Office

Office européen des brevets

(11) Veröffentlichungsnummer: **0 338 286**
**A1**

## EUROPÄISCHE PATENTANMELDUNG

(21) Anmeldenummer: 89105380.3

(22) Anmeldetag: 25.03.89

(51) Int. Cl.⁴: **C23C 18/22**

(30) Priorität: 18.04.88 DE 3813430

(43) Veröffentlichungstag der Anmeldung:
25.10.89 Patentblatt 89/43

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Mahlkow, Hartmut**
**Handjerystrasse 85**
**D-1000 Berlin 41(DE)**
Erfinder: **Seidenspinner, Hubert-Matthias, Dr.**
**Meschederweg 36**
**D-1000 Berlin 27(DE)**

(54) **Verfahren zur beidseitigen Metallisierung von Polyimid-Folien.**

(57) Die Erfindung betrifft ein Verfahren zur beidseitigen haftfesten Metallisierung von Polyimid-Folien durch Vorbehandlung und nachfolgende Aktivierung sowie chemische und gegebenenenfalls galvanische Metallisierung, dadurch gekennzeichnet, daß die Polyimidoberflächen mit einer Lösung von Alkalihydroxid in einem organischen Lösungsmittel vorbehandelt wird.

EP 0 338 286 A1

## VERFAHREN ZUR BEIDSEITIGEN METALLISIERUNG VON POLYIMID-FOLIEN

Die Erfindung betrifft ein Verfahren zur beidseitigen haftfesten Metallisierung von Polyimid-Folien durch Vorbehandlung und nachfolgende Aktivierung sowie chemische und gegebenenfalls galvanische Metallisierungen.

In der Elektronikindustrie werden seit etwa zwei Jahrzehnten integrierte Bauelemente in großer Zahl eingesetzt. Es handelt sich dabei überwiegend um gehäuste Siliziumchips (sog. Integrated Circuits IC's).

Integrierte Schaltungen werden heute vorwiegend mit der Drahtbondtechnik kontaktiert. Unter Einwirkung von Temperatur, Druck und Ultraschallenergie werden Gold- und Aluminiumdrähte plastisch verformt und durch Absättigung von freien Oberflächenbindungen wird eine haftfeste und zuverlässige Kontaktierung von Halbleiterchips erreicht. Das Drahtbondverfahren ist ein serieller Prozeß. Bei sehr hohen Anschlußzahlen muß die Ausbeute außerordentlich hoch sein (99,99%), um eine angemessene Produktionsrate von kontaktierten Chips zu erzielen.

In neuerer Zeit setzt die Indsutrie immer mehr SMD-(Surface Mounted Devices) Bauteile kleinster Bauart ein, wodurch die Verwendung von DIL-(Dual In Line) Gehäusen mit ihrem nachteilig großen Platzbedarf rückläufig ist.

Eine Lösung für die flächensparende Kontaktierung von IC'S bietet die TAB-(Tape Automated Bonding) Technik. Sie ist bereits seit etwa 1971 bekannt und wurde vorwiegend zur Kontaktierung und Montage von Chips in Standardgehäusen, für die Realisierung von Rechnersystemen und zur Herstellung der Mikro-Pack$^R$-Gehäuse eingesetzt. Die derzeit üblichen, relativ groben Strukturen der Metallbahnen auf den organischen Filmen reichen für die Kontaktierung von Chips mit geringen Anschlußzahlen und großen Bondpadflächen gerade aus.

Die bisher verwendeten TAB-Filme werden fast ausschließlich durch Auflaminieren von Kupferfolien auf vorgestanzte Polyimid-Tapes (Verbund mit Epoxidharzkleber) hergestellt (3 Lage-Technologie). Die Kupferfolien werden anschließend geätzt und soweit erforderlich metallisiert.

Aufgrund ihres Herstellungsprozesses weist die 3-Lagen-Technologie mehrere Nachteile auf, insbesondere den, daß die Polyimidstrukturierung nur über Stanzwerkzeuge möglich ist (Limitierung auf wenige Layouts, lange Entwicklungszeiten, keine Möglichkeit für Frane-Support durch Tape-Material).

Bei der derzeit verfügbaren 2-Lagentechnik (kleberfreie Produkte), wird das Grundmaterial im sogenannten Cast-On-Prozeß hergestellt.

Bedingt durch ein bislang noch ausstehendes Verfahren zur haftfesten Direktmetallisierung von Polyimidfolien wird dabei Flüssigimid auf Metallfolien aufgegossen. Auch in dieser Technologie läßt sich die gewünschte Produktgüte noch nicht erreichen. Dies beruht insbesondere auf der hier notwendigen Beschränkung auf dünne Polyimidschichten, ungenügender Biegebeanspruchbarkeit, mangelhaften Haftfestigkeiten, ungenügender Dimensionssstabilität sowie auf dem sogenannten "Aufrollverhalten" aufgrund entstehender Spannungen im Polyimid bei dessen Aushärtung.

Zur Herstellung des Support-Ringes und des TAB-Fensters wird das Polyimid bis zum Kupfer weggeätzt. Dazu werden Resiste benötigt, die dem Angriff des Ätzmediums widerstehen. Als Ätzmedien dienen in der Regel hochalkalische Lösungen mit Zusatzstoffen, als Resiste Fest- oder Flüssigresiste, die über einen Fotoprozeß strukturiert werden. Der Ätzprozeß stellt an sich keine technischen Anforderungen und wird beherrscht, Probleme gibt es jedoch bei der Auswahl geeigneter Resiste. Festresiste sind allgemein sehr spröde, was Verarbeitung von flexiblen Materialien erschwert. Flüssigresiste lassen sich nur dünn auftragen, wodurch die Verfahrenssicherheit bei der weiteren Verarbeitung nicht gewährleistet ist.

Bekannt ist, daß einige Metalle resistent gegen das Ätzmedium sind. Das Strukturätzen sollte also gelingen, wenn ein solches Metall porendicht in einer Schichtstärke von 3 - 5 mym auf das Polyimid gebracht wird, um als Resist zu wirken, vorausgesetzt, es haftet ausreichend auf dem Kunststoff und löst sich während des Ätzprozesses nicht ab.

Nach dem Polyimidätzprozeß kann die Metallschicht in üblicher Weise durch geeignete Lösungen entfernt werden.

Verfahren zur beidseitigen Metallisierung von Polyimidfolien sind bisher nicht bekannt.

Bekannt sind lediglich solche Verfahren, die sich mit der einseitigen Polyimidmetallisierung befassen. Dabei handelt es sich um naßchemische galvanische Prozesse, um den sogenannten Cast-On Prozeß oder um Prozesse, bei denen Metalle auf eine Polyimidoberfläche aufgedampft oder gesputtert werden.

Aufgabe der vorliegenden Erfindung ist die Zurverfügungstellung eines Verfahrens zur beidseitigen haftfesten Metallisierung von Polyimidfolien.

Diese Aufgabe wird erfindungsgemäß gelöst durch ein Verfahren gemäß dem kennzeichnenden Teil des Patentanspruchs.

Weitere Ausgestaltungen sind den Kennzeichnungsteilen der Unteransprüche zu entnehmen.

Das erfindungsgeäße Verfahren ermöglicht die beidseitige haftfeste Metallisierung von Polyimid-Folien und eröffnet damit überraschenderweise einen Weg zur Herstellung von TAB-Frames oder flexiblen Schaltungen unter Anwendung eines direkten chemischen-galvanotechnischen Verfahren.

Als organische Lösungsmittel, die erfindungsgemäß verwendet werden können, sind beispielsweise folgende zu nennen:

Alkohole wie
Methanol, Äthanol, n-Propanol, Isopropanol, n-Butanol, Isobutanol, sec-Butanol, tert-Butanol, n-Amylalkohol, Isoamylalkohol, n-Hexanol, 2-Äthylbutanol, Methylisobutylcarbinol, Cyclohexanol, Methylcyclohexanol, Benzylalkohol, Methylbenzylalkohol, Tetrahydrofurfurylalkohol, Furfurylalkohol oder Diacetonalkohol;

Ketone wie
Aceton, Methyläthylketon, Methyl-propylketon, Methyl-isopropylketon, Methylbutylketon, Methyl-isobutylketon, Methyl-n-amylketon, Methyl-isoamylketon, Diäthylketon, Äthylbutylketon, Äthylamylketon, Diisopropylketon, Cyclohexanon, Dimethylcyclohexanon, Mesityloxid, Isophoron oder Acetylaceton;

Äther und Glykoläther wie
Tetrahydrofuran, Dioxan, 2.2-Dimethyl-4-hydroxymethyl-1,3-dioxolan, Methylglykol, Äthylglykol, Propylglykol, Isopropylglykol, Butylglykol, Methyldiglykol, Äthyldiglykol, Butyldiglykol, Methyltriglykol, Äthyltriglykol, Butyltriglykol, Diglykoldimethyläther, Propylenglykolmethyläther oder Tripropylenglykolmethyläther;

Phenole wie
Phenol, o-Cresol, m-Cesol oder p-Cresol;

Ester wie
Methylformiat, Äthylformiat, Butylformiat, Isobutylformiat, Methylacetat, Äthylacetat, Propylacetat, Isopropylacetat, Butylacetat, Isobutylacetat, sec-Butylacetat, Amylacetat, Isoamylacetat, Cyclohexylacetat, Benzylacetat, Methylpropionat, Äthylpropionat, Propylpropionat, n-Butylpropionat, Äthylbutyrat, Propylbutyrat, n-Butylbutyrat, Isobutylbutyrat, Amylbutyrat, Methylisobutyrat, Äthylisobutyrat, Isopropylisobutyrat, Isobutylisobutyrat, Äthyllactat, Butyllactat, Glykolsäurebutylester, Methylglykolacetat, Äthylglykolacetat, Butylglykolacetat, Äthyldiglykolacetat, Butyldiglykolacetat, 3-Methoxybutylacetat, Äthylencarbonat, Propylencarbonat oder Butyrolacton;

Lösungsmittel wie
Dimethylacetal, Dimethylformamid, Dimethylacetamid, Dimethylsulfoxid, Furfurol oder N-Methylpyrrolidon;

Polyalkohole wie
1,2-Ethandiol, 1,2-Propandiol, 1,3-Propandiol, 1,3-Butandiol, 1,4-Butandiol, 2,3-Butandiol, 1,5-Pentandiol, 2-Ethyl-1,3-hexandiol, Glycerol oder 1,2,6-Hexantriol;

Amine wie
n-Propylamin, iso-Propylamin, n-,sec-Butylamin, tert-Butylamin, Diethylamin, Diethylentriamin, Cyclohexylamin, Triethylamin, Diisopropylamin, Dibutylamin, Ethanolamin, Morpholin, Ethylaminoethanol, Diemthylethanolamin, Diethanolamin, Diisopropanolamin, Triethanolamin oder Ethylendiamin;

Diese Lösungsmittel können jeweils allein oder auch in Mischung miteinander verwendet werden.

Das Polyimid wird vorzugsweise in Folienform verwendet. Erfindungsgemäß können jedoch auch Platten oder anders geformte Werkstücke aus Polyimid metallisiert werden.

Als Alkalihydroxide finden Lithium-, Natrium- und/oder Kaliumhydroxid oder deren Gemische Anwendung, vorzugsweise in Konzentration von 0,05 bis 50 g /Liter.

Die Durchführung des erfindungsgemäßen Verfahrens erfolgt durch Tauchen, Spülen und/oder der zu metallisierenden Polyimid-Waren mit der erfindungsgemäß zu verwendenden Lösung. Die Behandlungstemperatur und Dauer richtet sich nach der Qualität des Polyimids und beträgt etwa 15 bis 30°C, vorzugsweise 20°C, und erfordert etwa 5 bis 10 Minuten.

Die erfindungsgemäß zu verwendende Lösung kann in der gewünschten Zusammensetzung und Konzentration kurz vor der Behandlung bereitet werden. Jedoch lassen sich auch gelagerte Lösungen mit dem gleichen Erfolg verwenden.

Gewünschtenfalls können der Lösung mit Wasser mischbare, organische Lösungsmittel zusätzlich hinzugefügt werden, wie zum Beispiel Alkohole oder Ester, was ebenfalls zum Gegenstand dieser Erfindung gehört.

Die erfindungsgemäß vorbehandelten Teile werden nach der Behandlung gespült, zweckmäßigerweise mit Wasser, und sind dann bereit für die Aktivierung sowie chemische Metallisierung und gegebenenfalls galvanische Verstärkung.

Hierfür lassen sich die üblichen Aktivatoren, zweckmäßigerweise auf Basis eines palladiumhaltigen Aktivators, und Bäder, vorzugsweise chemische Kupfer- oder Nickelbäder, verwenden. Für die galvanische Verstärkung bedient man sich ebenfalls der üblichen Bäder, zum Beispiel eines Kupferbades.

Es hat sich für die Haftfestigkeit des abgeschiedenen Metalls als besonders günstig erwiesen, wenn die Materialien nach erfolgter Metallisierung auf 70 bis 140°C, vorzugsweise 130°C, erhitzt werden, wofür etwa 0,2 bis 2 Stunden ausreichend sind.

Die erfindungsgemäß hergestellten Verbundwerkstoffe sind überraschender Weise von bisher unerreichter Stabilität und lassen sich nur unter Zerstörung des gesamten Verbundes zerreißen, nicht aber trennen, was von außerordentlicher technischer Bedeutung ist.

Die erfindungsgemäß beidseitig metallisierten Polyimid-Folien beziehungsweise Werkstücke eignen sich in hervorragender Weise für Formteile, vorzugsweise TAB-Plates, und Ätzmasken, vorzugsweise TAB-Fenster, in der Elektronik.

Die folgenden Beispiele dienen zur Erläuterung der Erfindung.

## BEISPIEL 1

Eine Polyimidfolie von 50 μm Stärke wird mit einer alkalischen Methanollösung behandelt. (Im Methanol wird Natriumhydroxid bei Raumtemperatur bis zur Sättigungsgrenze gelöst).

Nach dem Spülen in Wasser erfolgt die Aktivierung im alkalischen Aktivator, wobei Palladiumionen von der Oberfläche des Polyimids absorbiert werden. Die Palladiumionen werden im anschließenden Bad mit Dimethylaminoboran oder Natriumborhydrid zum metallischen Palladium reduziert. Der dabei an das Palladium adsorptiv angelagerte Wasserstoff vermag im folgenden chemischen Bad den Start der außenstromlosen Metallisierung erheblich zu beschleunigen, so daß bei einer nur 5 minütigen Verweilzeit im Bad die chemische Schicht ausreichend dick ist, um die galvanische Verstärkung zu ermöglichen. Die galvanische Verstärkung erfolgt in einem sauren Kupferelektrolyten; zunächst bis auf 5 μm Kupferschichtdicke auf jeder Seite.

## BEISPIEL 2

Eine beidseitig mit 5 mym Kupfer beschichtete Polyimidfolie wird beidseitig mit geeigneten Fotoresisten beschichtet. Nach Auflage der Fotomaske wird die Leiterbahnseite und die TAB-Fensterseite belichtet und als erstes die Leiterbahnseite entwickelt. In den freigelegten Zonen erfolgt im galvanischen Bad der Aufbau der Leiterbahnen bis auf 40 mym Kupfer, gegebenenfalls im Anschluß daran galvanisch Zinn, Zinn/Blei oder Nickel-Gold. Es folgt die Strukturierung des Fotoresists (Entwicklung) auf der 2. Seite (TAB-Fensterseite) mit anschließenden Ätzen des freigelegten Kupfers (5 mym). Nun wird auf beiden Seiten der Resist gestrippt und das TAB-Fenster in einer Polyimid-Ätze geätzt, wobei die Kupferschicht als Metallresist wirkt.

Überraschenderweise verhindert Kupfer, auch in geringen Schichtdicken (5 mym), den Angriff auf das darunter liegende Polyimid und der hervorragende Verbund zwischen Kupfer und Polyimid den Angriff in der Horizontalen, so daß die geätzten Fenster scharfe Polyimidflanken ohne Unterätzung aufweisen.

Als letzter Arbeitsschritt folgt die Differenzätzung des Kupfers an der Oberfläche, bei der die Auflage von 5 mym Kupfer entfernt wird. Am Schluß liegt ein TAB Frame vor, das Leiterbahnen aufweist, einen durch Leiterbahnen gehaltenen Supportring und das TAB-Fenster in das die Innerlead-Bahnen hineinragen.

## Ansprüche

1. Verfahren zur beidseitigen haftfesten Metallisierung von Polyimid-Folien durch Vorbehandlung und nachfolgende Aktivierung sowie chemische und gegebenenfalls galvanische Metallisierung, dadurch gekennzeichnet, daß die Polyimidoberflachen mit einer Losung von Alkalihydroxid in einem organischen Losungsmittel vorbehandelt werden.

2. Verfahren nach Anspruch 1, dadurch gekennzeichnet, daß die Vorbehandlung durch Tauchen, Sprühen und/oder Spritzen der Folien erfolgt.

3. Verfahren nach Anspruch 1, dadurch gekennzeichnet, daß die Vorbehandlung bei Temperaturen von 15 bis 36° C, vorzugsweise Raumtemperatur, erfolgt.

4. Verfahren nach Anspruch 1, dadurch gekennzeichnet, daß als Alkalihydroxid Natriumhydroxid, Kaliumhydroxid und/oder Lithiumhydroxid verwendet wird.

5. Verfahren nach Anspruch 1, dadurch gekennzeichnet, daß die Lösung 0,05 bis 50 g / Liter Alkalihydroxid enthält.

6. Verfahren nach Anspruch 1, dadurch gekennzeichnet, daß als organisches Lösungsmittel ein Alkohol, ein Keton, ein Ether, ein Ester, ein mehrwertiger Alkohol, ein Ester eines mehrwertigen Alkohols, ein aromatischer Alkohol, ein Amin, ein heterocyclisches organisches Lösungsmittel oder deren Mischungen verwendet wird.

7. Verfahren nach Anspruch 1, dadurch gekennzeichnet, daß die Polyimid-Folien nach erfolgter Vorbehandlung durch einen alkalischen Palladiumaktivator aktiviert werden.

8. Verfahren gemäß Anspruch 7, dadurch gekennzeichnet, daß der Palladiumaktivator komplex gebundene Palladiumionen enthält.

9. Verfahren gemäß Anspruch 8, dadurch gekennzeichnet, daß die Konzentration an Palladiumionen 0,005 g bis 10 g / Liter beträgt.

10. Verfahren nach Anspruch 1, dadurch gekennzeichnet, daß die Polyimid-Folien nach erfolgter Vorbehandlung und Aktivierung in üblicher Weise chemisch metallisiert, vorzugsweise verkupfert oder vernickelt und gegebenenfalls galvanisch mit Metall verstärkt werden.

11. Verfahren gemäß Ansprüchen 1 bis 10 zur Herstellung beidseitig metallisierter Polyimid-Folien.

12. Beidseitig metallisierte Polyimid-Folien hergestellt nach Verfahren gemäß Ansprüchen 1 bis 10.

13. Verwendung der gemäß den Ansprüchen 1 bis 10 hergestellten beidseitig metallisierten Polyimid-Folien für Formteile, vorzugsweise TAB-Tapes in der Elektronik.

14. Verwendung der gemäß den Ansprüchen 1 bis 10 hergestellten beidseitig metallisierten Polyimid-Folien für Ätzmasken, vorzugsweise TAB-Fenster in der Elektronik.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 361 589 (LINDSEY) <br> * Spalte 2, Zeilen 22-23; Spalte 3, Zeilen 26-27; Spalte 9, Zeilen 29-32 * <br> --- | 1-12 | C 23 C 18/22 |
| X | US-A-4 426 253 (KREUZ) <br> * Ansprüche * <br> --- | 1-12 | |
| X | US-A-3 821 016 (DE ANGELO) <br> * Spalte 4, Zeilen 48-60 * <br> --- | 1-12 | |
| X | US-A-4 517 254 (GRAPENTIN) <br> * Spalte 2, Zeilen 60-63 * <br> --- | 1-12 | |
| X | IBM TECHNICAL DISCLOSURE BULLETIN, Band 13, Nr. 7, Dezember 1970, Seiten 1831-1832, New York, US; S.M. SCHUESSLER et al.: "Plating thru-holes in circuit boards having dielectric layers" <br> * Insgesamt * <br> --- | 1,2,4-10 | |
| X | IBM TECHNICAL DISCLOSURE BULLETIN, Band 20, Nr. 10, März 1978, Seite 3863, New York, US; O.R. ABOLAFIA et al.: "Etchant for polymide" <br> * Insgesamt * <br> ----- | 1,2,4,5,6 | **RECHERCHIERTE SACHGEBIETE (Int. Cl.4)** <br><br> C 23 C <br> H 05 K <br> C 08 J |

Der vorliegende Recherchenbericht wurde für alle Patentansprüche erstellt

| Recherchenort | Abschlußdatum der Recherche | Prüfer |
|---|---|---|
| DEN HAAG | 27-06-1989 | NGUYEN THE NGHIEP |

EPO FORM 1503 03.82 (P0403)